# EUROPÄISCHE PATENTANMELDUNG

(11) **EP 4 835 498 A1**
(43) Veröffentlichungstag der Anmeldung: **04.11.2026**
(21) Anmeldenummer: 25173542.9
(22) Anmeldetag: 30.04.2025
(51) Int. Cl.: G01R 21/133, G01R 19/25

(54) **VERFAHREN, LEISTUNGSMESSGERÄT UND MESSSYSTEM ZUM ERMITTELN DER ELEKTRISCHEN LEISTUNGSAUFNAHME IN EINEM HAUSHALTSNETZ**

(71) Anmelder: EET - Efficient Energy Technology GmbH, 8020 Graz (AT)
(72) Erfinder: GEBETSROITHER, Florian, 8010 Graz (AT); MUSSNIG, Stefan, 8020 Graz (AT); MÜLLER, Markus, 8010 Graz (AT); POLI, Michele, 8020 Graz (AT); SALCHER, Patrick, 8010 Graz (AT); WEINBERGER, Stephan, 8662 St. Barbara im Mürztal (AT)
(74) Vertreter: Weiser Voith Gugler Patentanwälte Partnerschaft

(57) **Zusammenfassung**

Verfahren (4), Leistungsmessgerät (5) und Messsystem zum Ermitteln (11) der elektrischen Leistungsaufnahme in einem mit einem Versorgungsnetz (2) verbundenen Haushaltsnetz (1) mit Anlagenerder (E) für Neutralleiter (N) und Schutzleiter (PE), umfassend die Schritte: Anschließen (6) einer Spannungsmesseinheit (7) an den Neutralleiter (N) und den Schutzleiter (PE) eines Verbraucheranschlusses (V) in einem Leitungszweig (Lᵢ) des Haushaltsnetzes (1); Messen (8) eines ersten zeitlichen Verlaufs (u_{Mi}) einer elektrischen Spannung (U_{Mi}) zwischen Neutralleiter (N) und Schutzleiter (PE) mit der Spannungsmesseinheit (7); Errechnen (10) eines Spannungswerts (uᵢ, u_{i,0}) aus dem gemessenen ersten zeitlichen Verlauf (u_{Mi}); und Ermitteln (11) der elektrischen Leistungsaufnahme im Haushaltsnetz (1) durch Vergleichen des errechneten Spannungswerts (uᵢ, u_{i,0}) mit zumindest einem gespeicherten oder empfangenen Referenzwert (RV).

## Beschreibung

Die vorliegende Erfindung betrifft ein Verfahren, ein Leistungsmessgerät und ein Messsystem zum Ermitteln der elektrischen Leistungsaufnahme in einem mit einem Versorgungsnetz verbundenen Haushaltsnetz, welches eine oder mehrere Netzphasen mit jeweils einem oder mehreren Leitungszweigen und in jedem Leitungszweig einen oder mehrere Verbraucheranschlüsse mit jeweils einem Außenleiter, einem Neutralleiter und einem Schutzleiter hat, wobei der Neutralleiter und der Schutzleiter an einen Anlagenerder des Haushaltsnetzes angeschlossen sind.

Verschiedene Netzformen sind bekannt und werden je nach Anwendung eingesetzt. In Europa werden Versorgungsnetze meist als dreiphasige Netze mit gegenseitigen Phasenwinkeln von 120° betrieben. Versorgungsnetze ohne Sternpunkterdung des Versorgungsnetztransformators werden als IT-Netze bezeichnet. Im TT-Netz wird im Unterschied dazu ein Punkt der Stromquelle - meist der Sternpunkt - der Niederspannungsseite des Netztransformators mit einem Betriebserder verbunden; der mit leitfähigen Gehäusen der elektrischen Betriebsmitteln im Haushaltsnetz verbundene Schutzleiter wird dabei separat mit einem lokalen Erder, dem Anlagenerder, verbunden. Im Gegensatz dazu haben TN-Netze stets einen geerdeten Sternpunkt des Versorgungsnetztransformators und einen davon ausgehenden Neutralleiter. Sind dabei der Neutralleiter und die leitfähigen Betriebsmittel im Haushaltsnetz ohne Anlagenerder mit dem Neutralleiter verbunden, der zugleich den Schutzleiter bildet ("PEN-Leiter"), spricht man vom einem TN-C-System, welches in Haushaltsnetzen heute nicht mehr üblich ist. Sind vom geerdeten Sternpunkt des Versorgungsnetztransformators aus sowohl Neutral- als auch Schutzleiter, d.h. als N- und davon separater PE-Leiter, bis zum Haushaltsnetz geführt und die leitfähigen Betriebsmittel mit diesen beiden ohne Anlagenerder verbunden, ist dies ein TN-S-System. Bei dem heute häufigsten TN-C-S-System wird wie beim TN-C-System ein PEN-Leiter vom Versorgungsnetztransformator zum Haushaltsnetz geführt, dort erneut über einen Anlagenerder geerdet, von welchem aus ein Neutralleiter ein davon separater Schutzleiter zum Haushaltsnetz führen. Dabei werden in Europa im Haushaltsnetz häufig in separaten Leitungszweigen jeder Außenleiter zur einphasigen Versorgung mit 230V Wechselspannung gegenüber dem Neutralleiter geschaltet und die drei Außenleiter gemeinsam als 3 x 400V Drehstrom für größere Verbraucher und/oder dreiphasige Motoren, z.B. Wärmepumpen, elektrische Heizungen oder Boiler, Pumpen/Lüfter , genutzt.

In den USA sind Haushaltsnetze meist als Einphasen-Dreileiternetze aufgebaut; dabei ist einer der drei Leiter geerdet und die anderen beiden führen gegenphasig - gleichsam unter einer gegenseitigen Phasenverschiebung von 180° - jeweils 120V Wechselspannung. Dies liegt an den weit verbreiteten Mast-Transformatoren, welche versorgerseitig von einer einzelnen Mittelspannungsleitung gespeist werden und dezentral nahe am Haushaltsnetz angeordnet sind. Haushaltsseitig liefern diese Transformatoren 240V mit der genannten geerdeten Mittelabzweigung als Neutralleiter. Ähnliche Systeme, wenn auch mit meist anderen Spannungsniveaus sind in Kanada, Australien und Großbritannien in Gebrauch. Auch in diesen Fällen sind somit der Neutralleiter und der Schutzleiter beim Mast-Transformator an einen Anlagenerder des Haushaltsnetzes angeschlossen.

Die elektrische Leistungsaufnahme in einem mit einem Versorgungsnetz verbundenen Haushaltsnetz wird im Allgemeinen mit einem Stromzähler ermittelt, der dem Haushaltsnetz jeweils vorgeschaltet ist, um die gesamte, von allen Verbrauchern des Haushaltsnetzes aufgenommene elektrische Leistung zu messen und über die Zeit zu einer verbrauchten Energie aufzusummieren bzw. aufzuintegrieren. Anstelle früherer elektromechanischer Stromzähler werden neuerdings "Smart Meter" verwendet, welche einzelne Leistungsmesswerte zu Messzeitpunkten aufzeichnen, nicht bloß aufsummieren. Dem Haushalt werden die Messwerte aus einem Smart Meter jedoch, wenn überhaupt, bloß im Nachhinein und meist nicht mit allen Details übermittelt.

Um das Verbrauchsverhalten im Haushalt optimieren und allenfalls Energie aus regenerativen Quellen, z.B. einer batteriegepufferten Photovoltaikanlage, gezielt bei hohem Momentanverbrauch, d.h. bei hoher momentaner elektrischer Leistungsaufnahme des Haushaltsnetzes, in das Haushaltsnetzwerk einspeisen zu können und so im Haushaltsnetz anfallende Spitzenlasten abzudecken, wäre es jedoch vorteilhaft, die Leistungsaufnahme im Haushaltsnetz, d.h. zumindest in einzelnen Leitungszweigen darin, stets aktuell zu ermitteln. Ein Rückspeisen in das Versorgungsnetz soll angesichts niedriger Rückspeisetarife und zur Vermeidung von Instabilitäten im Versorgungsnetz vermieden werden. Der Einbau eines weiteren, dem Haushalt direkt zugänglichen Smart Meters kommt aufgrund mangelnden Zugangs, oft mangelnder Berechtigung und der erforderlichen baulichen Maßnahmen meist nicht in Frage.

Aus der WO 2012/065078 A2 ist ein Messgerät bekannt, welches an einen Verbraucheranschluss im Haushaltsnetz angeschlossen wird und zum Messen der vom Haushaltsnetz gerade aufgenommene elektrische Leistung ein Messsignal in den Verbraucheranschluss einspeist und aus der Signalantwort des Haushaltsnetzes den augenblicklichen Leitwert des Haushaltsnetzes schätzt. Der Leitwert G ist der gesuchten elektrischen Leistung P über die Beziehung P = V² * G bei konstanter Netzspannung V proportional. Durch Verwendung eines Messsignals hoher Frequenz wird der Einfluss außerhalb des Haushaltsnetzes liegender Netze auf das Messergebnis abgeschwächt; aus Messungen bei verschiedenen Frequenzen kann ferner der Leitwert bei Netzfrequenz extrapoliert werden. Dieses Verfahren liefert eine brauchbare Grobabschätzung der elektrischen Leistungsaufnahme des Haushaltsnetzes, ist jedoch für manche Anwendungen zu ungenau.

Aus der EP 4 403 930 A1 ist eine an einen Verbraucheranschluss anschließbare Vorrichtung bekannt, die eine Folge von Messsignalen unterschiedlicher Frequenz in den Verbraucheranschluss einkoppelt und die elektrische Leistungsaufnahme aus den zu den Messsignalen erfassten Signalantworten ermittelt. Das Bandpassfilter filtert Störsignale der Verbraucher, die abseits seiner Mittenfrequenz liegen, aus und steigert dadurch die Genauigkeit in der Ermittlung der Leistungsaufnahme wesentlich.

Die Erfindung setzt sich zum Ziel, ein Verfahren, ein Leistungsmessgerät und ein Messsystem zu schaffen, welche die elektrische Leistungsaufnahme in einem Haushaltsnetz einfacher und dennoch präzise ermitteln lassen.

Dieses Ziel wird in einem ersten Aspekt der Erfindung mit einem Verfahren der einleitend genannten Art erreicht, welche die folgenden Schritte umfasst:
Anschließen einer Spannungsmesseinheit an den Neutralleiter und den Schutzleiter eines der Verbraucheranschlüsse;
Messen eines ersten zeitlichen Verlaufs einer elektrischen Spannung zwischen dem Neutralleiter und dem Schutzleiter mit der Spannungsmesseinheit;
Errechnen eines Spannungswerts aus dem gemessenen ersten zeitlichen Verlauf; und
Ermitteln der elektrischen Leistungsaufnahme im Haushaltsnetz durch Vergleichen des errechneten Spannungswerts mit zumindest einem gespeicherten oder empfangenen Referenzwert.

Der Erfindung liegt die Erkenntnis zugrunde, dass in einem Haushaltsnetz, welches eine oder mehrere Netzphasen mit jeweils einem oder mehreren Leitungszweigen und in jedem Leitungszweig einen oder mehrere Verbraucheranschlüsse mit jeweils einem Außenleiter, einem Neutralleiter und einem Schutzleiter hat, wobei der Neutralleiter und der Schutzleiter an einen Anlagenerder des Haushaltsnetzes angeschlossen ist, sodass infolge der Impedanzen zwischen dem Neutralleiter und dem Schutzleiter ein von der Leistungsaufnahme in dem Leitungszweig mit dem Verbraucheranschluss abhängiger Spannungsabfall messbar ist. Die relevanteste der Impedanzen zwischen Neutralleiter und Schutzleiter eines Verbraucheranschlusses ist im Allgemeinen die Leitungsimpedanz des Neutralleiters infolge der im Vergleich zum Versorgungsnetz geringen Leiterquerschnitte bei nicht unbedeutenden Leitungslängen im Haushaltsnetz zuzüglich der Impedanz des Schutzschalters und aller Klemmen. Der Spannungsabfall ist der Leistungsaufnahme im Leitungszweig proportional und liegt bei mittlerer bis höherer Leistungsaufnahme in der Größenordnung von mehreren Volt, sodass er zuverlässig messbar ist. Gerade die Leistungsaufnahme von leistungsstärkeren Verbrauchern, welche zur Optimierung des Verbrauchsverhaltens und zur Steuerung der Energieeinspeisung in das Haushaltsnetz ausschlaggebend sind, ist auf diese Weise mit hoher Präzision ermittelbar. Zur Steuerung der Energieeinspeisung in das Haushaltsnetz kann die Leistungsaufnahme auch ermittelt werden, indem die Recheneinheit mit einem Sendeempfänger verbunden ist, über welchen eine separate Einspeiseeinheit derart gesteuert werden kann, dass der genannte errechnete Spannungswert eine vorgegebene Größe annimmt, z.B. nahe null bleibt, wenn die Einspeiseeinheit in denselben Leitungszweig einspeist. Dabei sendet die Einspeiseeinheit ihre momentane Einspeiseleistung als Referenzwert, welchen die Recheneinheit über ihren Sendeempfänger empfängt und welcher der Leistungsaufnahme im Haushaltsnetz entspricht, wenn die Einspeiseeinheit in denselben Leitungszweig einspeist oder, wenn nicht, aus welcher die Leistungsaufnahme ermittelt werden kann.

Außergewöhnlich ist an diesem Verfahren ferner, dass nicht nur die aufgenommene Leistung jener Verbraucher im Haushaltsnetz ermittelt werden kann, die in demselben Leitungszweig wie die Spannungsmesseinheit angeschlossen sind, sondern auch die Leistung von Verbrauchern, die an andere Leitungszweige, sogar in anderen Netzphasen des Haushaltsnetzes angeschlossen sind, wie im Folgenden erläutert wird.

Der weiter oben genannte errechnete Spannungswert kann eine augenblickliche Größe der Spannung sein, z.B. ein Scheitelwert des gemessenen ersten zeitlichen Verlaufs, oder diesen umfassen. Ferner kann der Spannungswert aus mehreren Größen zusammengesetzt sein, d.h. diese umfassen, z.B. komplexwertig sein mit einem Betrag und einem Phasenwinkel und/oder einen Satz von Größen umfassen, die gemeinsam den gesamten Spannungswert bilden. Günstig ist, wenn der errechnete Spannungswert einen Effektivwert und/oder Gleichrichtwert des gemessenen ersten zeitlichen Verlaufs umfasst. Effektivwert und Gleichrichtwert sind schon aufgrund ihrer Mittelwertbildung weniger rauschanfällig als Augenblicksgrößen und daher präziser und zugleich einfach zu errechnen. Ferner entfallen Abweichungen infolge von Vorzeichenänderungen in Wechselstromsystemen.

Besonders vorteilhaft ist, wenn im genannten Schritt des Anschließens die Spannungsmesseinheit ferner an den Außenleiter des genannten Verbraucheranschlusses angeschlossen wird, wobei im genannten Schritt des Messens ferner ein zweiter zeitlicher Verlauf einer elektrischen Spannung zwischen dem Außenleiter und dem Neutralleiter mit der Spannungsmesseinheit gemessen wird, und wobei der errechnete Spannungswert einen mit der Frequenz und der Phasenlage der elektrischen Spannung zwischen dem Außenleiter und dem Neutralleiter modulierten Integralwert des gemessenen ersten zeitlichen Verlaufs umfasst. Der auf diese Weise modulierte Integralwert ist umso größer, je näher die Phasenlage des ersten jener des zweiten zeitlichen Verlaufs, d.h. die Phasenlage der elektrischen Spannung zwischen Neutralleiter und Schutzleiter jener der elektrischen Spannung zwischen Außenleiter und Neutralleiter, ist. Mathematisch betrachtet handelt es sich bei der Modulation um eine Faltung des ersten und zweiten zeitlichen Verlaufs. Anhand der Phasenlage lässt sich beim Ermitteln die Leistungsaufnahme von Verbrauchern in jenem Leitungszweig und jener Netzphase des Haushaltsnetzes, in welcher der Leitungszweig mit dem Verbraucheranschluss liegt, an welchen die Spannungsmesseinheit angeschlossen ist, von anderen unterscheiden. Es versteht sich, dass der Begriff "Integralwert", da die Spannungsmesseinheit den ersten und zweiten zeitlichen Verlauf meist nicht kontinuierlich sondern diskret - also durch Abtastung - misst, auch eine entsprechende Summenbildung, d.h. einen Summenwert, miteinschließt.

Bevorzugt wird der Integralwert als phasenabhängiger Wert gemäß: ${u}_{i , 0} \left(t\right) = \frac{1}{T} {\int }_{{t}_{S} - T}^{{t}_{S}} sin \left(2{πf}_{Li}⋅t\right) ⋅ {u}_{Mi} \left(t\right) dt$ errechnet wird, mit:
- u_{i,0}: Integralwert des gemessenen ersten zeitlichen Verlaufs u_{Mi} der elektrischen Spannung zwischen dem Neutralleiter und dem Schutzleiter für jene Netzphase des Haushaltsnetzes, in welcher der Leitungszweig mit dem Verbraucheranschluss liegt, an welchen die Spannungsmesseinheit angeschlossen ist;
- i: Leitungszweig mit dem Verbraucheranschluss, an welchen die Spannungsmesseinheit angeschlossen ist;
- t_{S}: Zeitpunkt des Endes der Messung;
- T: Zeitspanne der Messung; und
- f_{Li}: Frequenz der Spannung zwischen dem Außenleiter und dem Neutralleiter im genannten Leitungszweig.

Dieses Integral kann gleichartig mit Cosinus statt Sinus aufgestellt werden. Aus der Phase Sensitive Detection ist es auch als "PSD-Integral" bekannt. Da es vom Phasenwinkel zwischen dem gemessenen ersten und dem gemessenen zweiten zeitlichen Verlauf abhängig ist, lässt sich auf die Leistungsaufnahme in den einzelnen Netzphasen schließen.

In einer vorteilhaften Variante wird zu diesem Zweck im genannten Schritt des Errechnens bevorzugt der Integralwert für jede Netzphase und daraus für jede Netzphase ein eigener Spannungswert mit zugehörigem Phasenwinkel gegenüber dieser Netzphase errechnet, wobei im genannten Schritt des Ermittelns die elektrische Leistungsaufnahme in jeder Netzphase des Haushaltsnetzes durch Vergleichen der für jede Netzphase errechneten Spannungswerte mit jeweils für diese Netzphase gespeicherten oder empfangenen Referenzwerten ermittelt wird. In der Varianten mit PSD-Integral können so auf Grundlage einer Messung des ersten zeitlichen Verlaufs in einer einzigen Netzphase bzw. einem einzigen Leitungszweig infolge der im Allgemeinen bekannten Phasenwinkel zwischen den Netzphasen des Haushaltsnetzwerks auch entsprechende PSD-Integrale für die weiteren Netzphasen aufgestellt werden, z.B. bei einem gegenseitigen Phasenwinkel von 120° der Netzphasen gemäß: ${u}_{i , 120} \left(t\right) = \frac{1}{T} {\int }_{{t}_{S} - T}^{{t}_{S}} sin \left(2{πf}_{Li}⋅t+120°\right) ⋅ {u}_{Mi} \left(t\right) dt bzw . {u}_{i , 120} \left(t\right) = \frac{1}{T} {\int }_{{t}_{S} - T}^{{t}_{S}} sin \left(2{πf}_{Li}⋅t+\frac{2 π}{3}\right) ⋅ {u}_{Mi} \left(t\right) dt$ und ${u}_{i , 240} \left(t\right) = \frac{1}{T} {\int }_{{t}_{S} - T}^{{t}_{S}} sin \left(2{πf}_{Li}⋅t+240°\right) ⋅ {u}_{Mi} \left(t\right) dt bzw . {u}_{i , 240} \left(t\right) = \frac{1}{T} {\int }_{{t}_{S} - T}^{{t}_{S}} sin \left(2{πf}_{Li}⋅t+\frac{4 π}{3}\right) ⋅ {u}_{Mi} \left(t\right) dt$ jeweils mit:
u_{i,120}Integralwert des gemessenen ersten zeitlichen Verlaufs für die gegenüber jener Netzphase des Haushaltsnetzes, in welcher der Leitungszweig mit dem Verbraucheranschluss liegt, an welchen die Spannungsmesseinheit angeschlossen ist, um 120° (bzw. 2π/3) verschobene Netzphase; und
u_{i,240} Integralwert des gemessenen ersten zeitlichen Verlaufs für die gegenüber jener Netzphase des Haushaltsnetzes, in welcher der Leitungszweig mit dem Verbraucheranschluss liegt, an welchen die Spannungsmesseinheit angeschlossen ist, um 240° (bzw. 4π/3) verschobene Netzphase.

Daraus lässt sich der Phasenwinkel φᵢ gegenüber der Phasenlage der gemessenen Netzphase beispielsweise bestimmen gemäß: ${φ}_{i} = arctan \left(\frac{{Q}_{i}}{{I}_{i}}\right)$ mit: ${I}_{i} = \frac{2}{3} \left({u}_{i , 0}-\frac{1}{2}⋅{u}_{i , 120}-\frac{1}{2}⋅{u}_{i , 240}\right) ,$ und ${Q}_{i} = \frac{1}{\sqrt{3}} \left({u}_{i , 120}-{u}_{i , 240}\right) .$

Die Phasenwinkel φᵢ gegenüber den anderen Netzphasen ergeben sich aus der gegenseitigen 120°-Phasenverschiebung. Es versteht sich, dass diese Auswertung nicht auf die Verwendung von PSD-Integralen beschränkt ist.

Alternativ oder ergänzend dazu ist günstig, wenn im genannten Schritt des Anschließens die Spannungsmesseinheit ferner an den Außenleiter des genannten Verbraucheranschlusses angeschlossen wird, wobei im genannten Schritt des Messens ferner ein zweiter zeitlicher Verlauf einer elektrischen Spannung zwischen dem Außenleiter und dem Neutralleiter mit der Spannungsmesseinheit gemessen wird, wobei im genannten Schritt des Errechnens mithilfe einer Fourier-Transformierten des gemessenen ersten zeitlichen Verlaufs für jede Netzphase ein eigener Spannungswert mit zugehörigem Phasenwinkel gegenüber dieser Netzphase errechnet wird, und wobei im genannten Schritt des Ermittelns die elektrische Leistungsaufnahme in jeder Netzphase des Haushaltsnetzes ermittelt wird. Aus der komplexwertigen Fourier-Transformierten kann der Spannungswert mitsamt seinem Phasenwinkel gegenüber jeder Netzphase errechnet werden. Im Allgemeinen wird die Fourier-Transformierte mithilfe eines Fast-Fourier-Transformationsalgorithmus ("FFT"-Algorithmus) errechnet. Dabei können, falls gewünscht, in einem Filterschritt jene Frequenzanteile der Fourier-Transformierten, die von der Netzfrequenz deutlich abliegen, beim Ermitteln der Leistung einfach unberücksichtigt bleiben.

Grundsätzlich können der erste und der zweite zeitliche Verlauf zu beliebiger Zeit gemessen werden. Besonders vorteilhaft ist, wenn der genannte Schritt des Messens über eine Zeitspanne von zwei ganzen Netzperioden, bevorzugt beginnend mit einem Nulldurchgang des genannten zweiten zeitlichen Verlaufs der elektrischen Spannung zwischen dem Außenleiter und dem Neutralleiter, besonders bevorzugt einem Nulldurchgang von negativer zu positiver Spannung, durchgeführt wird. Ein Messen über ganze Netzperioden ist schon deshalb vorteilhaft, weil nichtlineare Verbraucher - z.B. phasenanschnittsgesteuerte Verbraucher - dabei korrekt erfasst werden. Überdies wird das Errechnen der Integralwerte bzw. der Fourier-Transformierten dadurch vereinfacht. Das Messen über zwei ganze Netzperioden hilft, einmalige Einflüsse innerhalb einer Netzperiode abzuschwächen, und ist kurz genug, um Änderungen der Verbraucher, insbesondere das Zu- und Abschalten eines Verbrauchers rasch zu messen. Das Messen vom Nulldurchgang der Spannung an erhöht die Symmetrie des Messergebnisses und die Einheitlichkeit über mehrere aufeinanderfolgende Messungen, außerdem ist der Nulldurchgang einfacher festzustellen als z.B. ein Scheitelwert und ist das Messen vom Nulldurchgang von negativer zu positiver Spannung in Verbindung mit der Verwendung des Sinus im PSD-Integral besonders zweckmäßig.

Da sich in einem dreiphasigen Haushaltsnetz mit jeweils 120° Phasenverschiebung zwischen den drei Phasen bei annähernd gleichmäßiger Leistungsaufnahme in allen Phasen die Summe aller Ströme am Neutralleiter zumindest weitgehend aufheben, ist in diesem Fall auch die zwischen Neutralleiter und Schutzleiter gemessene Spannung geringer als es der tatsächlichen Leistungsaufnahme entspräche. Dasselbe gilt für Einphasen-Dreileiternetze, wenn die Leistungsaufnahme in den beiden gegenphasigen Außenleitern jeweils annähernd gleich ist. In diesem Fall ist das Ermitteln der elektrischen Leistungsaufnahme im Haushaltsnetz erschwert. Daher wird das Verfahren besonders bevorzugt wiederholt ausgeführt und dabei im genannten Schritt des Errechnens für jede Netzphase ermittelt, ob gegenüber der vorhergehenden Ausführungswiederholung ein Spannungssprung aufgetreten ist, und wobei im genannten Schritt des Errechnens der Spannungswert für diese Netzphase durch Kombination des für diese Netzphase in der vorhergehenden Ausführungswiederholung errechneten Spannungswerts und des ermittelten Spannungssprungs errechnet wird. Dabei wird der errechnete Spannungswert um den jeweils errechneten Spannungssprung, je nach Sprungrichtung, erhöht bzw. reduziert. Da die Wahrscheinlichkeit, dass in allen Netzphasen stets gleichzeitig annähernd gleich große Verbraucher zu- oder abgeschaltet werden, äußerst gering ist, führt diese Ausführungsform des Verfahrens zu besonders präzisen Ergebnissen. Auch Änderungen im Verbrauch während des Messens des ersten zeitlichen Verlaufs - z.B. über zwei ganze Netzperioden - können dabei erfasst werden.

Der genannte zumindest eine Referenzwert kann - wenn er nicht empfangen wird - entweder als Schätzung vorgegeben werden, z.B. aus Erfahrungswerten bzw. anhand einer Simulation. In Ergänzung oder alternativ dazu ist günstig, wenn das Verfahren ferner ein dem genannten Schritt des Ermittelns vorgelagertes Bestimmen des zumindest einen Referenzwerts mit den folgenden Teilschritten umfasst:
Anschließen und Einschalten eines Verbrauchers mit vorbekannter Leistung an den Leitungszweig mit dem Verbraucheranschluss, an welchen die Spannungsmesseinheit angeschlossen ist;
Messen eines ersten zeitlichen Verlaufs einer elektrischen Spannung zwischen dem Neutralleiter und dem Schutzleiter mit der Spannungsmesseinheit vor und nach dem Einschalten des Verbrauchers; und
Errechnen jeweils zumindest eines Spannungswerts aus dem gemessenen ersten zeitlichen Verlauf der elektrischen Spannung vor und nach dem Einschalten des Verbrauchers und Bestimmen des zumindest einen Referenzwerts aus der Differenz der errechneten Spannungswerte vor und nach dem Einschalten des Verbrauchers.

Der vorbekannte Verbraucher kann beispielsweise ein speziell dafür ausgebildeter z.B. Lastwiderstand sein oder ein im Haushalt verfügbarer Verbraucher bekannter Leistung, z.B. ein Haarfön, ein Heizstrahler etc. Im einfachsten Fall wird dabei ein Verhältnis zwischen der Differenz der errechneten Spannungswerte vor und nach dem Einschalten des Verbrauchers und der vorbekannten Nennleistung des Verbrauchers ermittelt und dieses Verhältnis verwendet, um später im genannten Schritt des Ermittelns die elektrische Leistungsaufnahme im Haushaltsnetz aus dem zuvor errechneten Spannungswert und dem genannten Verhältnis zu ermitteln. Es versteht sich, dass der Verbraucher auch negative Leistung haben könnte, d.h. eine Einspeiseeinheit mit bekannter Einspeiseleistung oder eine Einspeiseeinheit, von welcher die Einspeiseleistung als Referenzwert empfangen wird, sein könnte. Ferner könnte, um den Referenzwert genauer zu bestimmen und/oder weitere Referenzwerte zu bestimmen, der Verbraucher z.B. nacheinander an verschiedene Verbraucheranschlüsse - auch verschiedener Leitungszweige und Netzphasen - angeschlossen, jeweils der zeitliche Verlauf gemessen und aus den errechneten Spannungswerten der bzw. Referenzwert/e bestimmt werden.

Alternativ oder ergänzend ist vorteilhaft, wenn das Verfahren ferner ein begleitendes Kalibrieren des zumindest einen Referenzwerts umfasst, wobei das Verfahren wiederholt ausgeführt und der im genannten Schritt des Errechnens errechnete Spannungswert wiederholt mit dem zumindest einen Referenzwert verglichen und bei Überschreiten als zumindest ein neuer Referenzwert gespeichert wird. Auf diese Weise wird der Referenzwert laufend kalibriert, um Veränderungen im Haushaltsnetz auszugleichen und/oder Ungenauigkeiten im Referenzwert zu korrigieren.

Besonders vorteilhaft ist, wenn im genannten Schritt des Anschließens an zwei in verschiedenen Leitungszweigen ein und derselben oder zweier verschiedener Netzphase/n des Haushaltsnetzes liegende Verbraucheranschlüsse jeweils eine Spannungsmesseinheit an den Neutralleiter und den Schutzleiter angeschlossen wird, und wobei in einem zusätzlichen Schritt des Übertragens entweder die von den beiden Spannungsmesseinheiten im genannten Schritt des Messens jeweils gemessenen zeitlichen Verläufe oder die aus den jeweils gemessenen zeitlichen Verläufen errechneten Spannungswerte an eine zentrale Recheneinheit übertragen werden, welche entweder anhand der übertragenen zeitlichen Verläufe die genannten Schritte des Errechnens und Ermittelns oder anhand der übertragenen Spannungswerte den genannten Schritt des Ermittelns ausführt. Dabei kann die Leistungsaufnahme im Haushaltsnetz noch präziser ermittelt werden, insbesondere wenn die beiden genannten Verbraucheranschlüsse in Leitungszweigen verschiedener Netzphasen liegen, da dadurch die Spannungswerte zu diesen beiden Netzphasen und daraus der Leistungsverbrauch in diesen beiden Netzphasen unmittelbar und jener in der dritten Netzphase durch Ausschluss ebenso werden kann.

In einem zweiten Aspekt schafft die Erfindung ein Leistungsmessgerät zum Ermitteln der elektrischen Leistungsaufnahme in einem mit einem Versorgungsnetz verbundenen Haushaltsnetz, welches eine oder mehrere Netzphasen mit jeweils einem oder mehreren Leitungszweigen und in jedem Leitungszweig mehrere Verbraucheranschlüsse mit jeweils einem Außenleiter, einem Neutralleiter und einem Schutzleiter hat, wobei der Neutralleiter und der Schutzleiter an einen Anlagenerder des Haushaltsnetzes angeschlossen sind, wobei das Leistungsmessgerät eine Spannungsmesseinheit, welche an den Neutralleiter und den Schutzleiter eines der Verbraucheranschlüsse anschließbar und dazu ausgebildet ist, den Schritt des Messens des vorgenannten Verfahrens auszuführen, und eine Recheneinheit umfasst, welche an die Spannungsmesseinheit angeschlossen und dazu ausgebildet ist, die Schritte des Errechnens und Ermittelns des vorgenannten Verfahrens auszuführen.

Vorteilhaft ist, wenn die Spannungsmesseinheit ferner an den Außenleiter des genannten Verbraucheranschlusses anschließbar und dazu ausgebildet ist, den Schritt des Messens des vorgenannten Verfahrens auch unter Messen des zweiten zeitlichen Verlaufs der elektrischen Spannung zwischen dem Außenleiter und dem Neutralleiter auszuführen, und wobei die Recheneinheit dazu ausgebildet ist, die Schritte des Errechnens und Ermittelns des vorgenannten Verfahrens auszuführen.

In einem dritten Aspekt schafft die Erfindung ein Messsystem mit zumindest zwei Leistungsmessgeräten der vorgenannten Art, deren Spannungsmesseinheiten an jeweils einen Verbraucheranschluss anschließbar sind, welche Verbraucheranschlüsse in verschiedenen Leitungszweigen ein und derselben oder zweier verschiedener Netzphase/n des Haushaltsnetzes liegen, wobei eines der Leistungsmessgeräte einen Sender und das andere Leistungsmessgerät einen Empfänger und jene Recheneinheit hat, welche die genannte zentrale Recheneinheit bildet, und wobei das genannte eine Leistungsmessgerät dazu ausgebildet ist, entweder den von seiner Spannungsmesseinheit gemessenen ersten zeitlichen Verlauf oder den von seiner Recheneinheit aus dem gemessenen ersten zeitlichen Verlauf jeweils errechneten Spannungswert über den Sender an die Recheneinheit des genannten anderen Leistungsmessgeräts zu übertragen, und das genannte andere Leistungsmessgerät dazu ausgebildet ist, den von seiner Spannungsmesseinheit gemessenen ersten zeitlichen Verlauf an seine Recheneinheit zu übertragen und die genannten Schritte des Errechnens und Ermittelns anhand des/der übertragenen ersten zeitlichen Verlaufs/Verläufe und anhand der übertragenen und/oder errechneten Spannungswerte auszuführen.

In Bezug auf weitere Ausführungsformen und Vorteile der Leistungsmessgeräte und des Messsystems wird auf die vorausgegangenen Ausführungen zum Verfahren verwiesen.

Die Erfindung wird nachfolgend anhand von in den beigeschlossenen Zeichnungen dargestellten Ausführungsbeispielen näher erläutert. In den Zeichnungen zeigen:
Fig. 1 zwei beispielhafte mit einem Versorgungsnetz verbundene Haushaltsnetzwerke in einem schematischen Ersatzschaltbild;
Fig. 2 das erfindungsgemäße Verfahren zum Ermitteln der elektrischen Leistungsaufnahme in einem Haushaltsnetz in einem Flussdiagramm;
die Fig. 3a bis 3c ein Haushaltsnetz mit einer erfindungsgemäßen Leistungsmesseinheit zur Durchführung des Verfahrens von Fig. 2 in einem Zustand geringer Leistungsaufnahme (Fig. 3a), hoher Leistungsaufnahme in einem ersten Leitungszweig (Fig. 3b) und zusätzlich mittlerer Leistungsaufnahme in einem zweiten Leitungskreis (Fig. 3c) jeweils in einem schematischen Ersatzschaltbild;
Fig. 4 Beispiele für mehrere nach dem Verfahren von Fig. 2 errechnete Spannungswerte in dem Haushaltsnetz der Fig. 3a bis 3c in einem schematisierten Diagramm über der Zeit; und
Fig. 5 weitere Beispiele für mehrere nach dem Verfahren von Fig. 2 errechnete Spannungswerte in dem Haushaltsnetz der Fig. 3a bis 3c in einem schematisierten Diagramm über der Zeit.

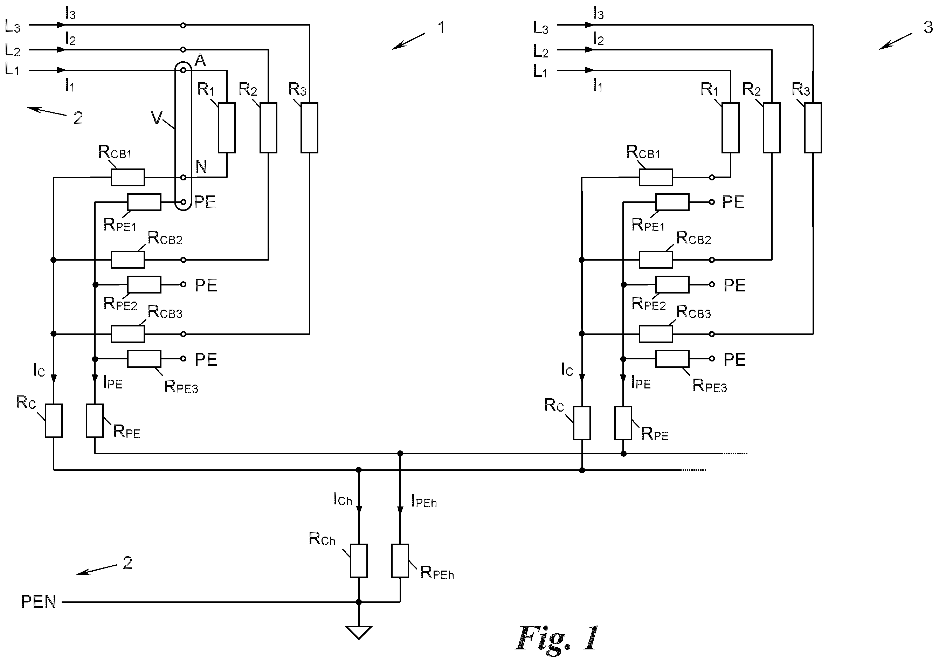

Fig. 1 zeigt ein beispielhaftes Haushaltsnetz 1, welches an ein hier nicht näher dargestelltes Versorgungsnetz 2 angeschlossen ist. Das Haushaltsnetz 1 hat einen oder mehrere (hier: drei) Leitungszweige L₁, L₂, L₃, ..., allgemein Lᵢ. Jeder Leitungszweig Lᵢ hat einen oder mehrere Verbraucheranschlüsse V mit jeweils einem Kontakt für einen Außenleiter A, einen Neutralleiter N und einen Schutzleiter PE. An jeden Verbraucheranschluss V des Leitungszweigs Lᵢ kann zwischen dem Außenleiter A und dem Neutralleiter N ein Verbraucher R₁, R₂, R₃, ..., allgemein Rᵢ, angeschlossen sein bzw. zu- oder abgeschaltet werden, z.B. ein elektrisches Küchen- oder Haushaltsgerät, Beleuchtung, eine elektrische Heizung, elektronische Geräte usw. usf.

Das hier nicht näher dargestellte Versorgungsnetz 2 hat im Allgemeinen eine Energiequelle, z.B. einen Generator, einen Transformator etc. Für das Versorgungsnetz 2 - und davon abhängig für das Haushaltsnetz 1 - sind verschiedene Netzformen bekannt, beispielsweise in Europa insbesondere dreiphasige Netze, bei welchem die einzelnen Netzphasen gegeneinander Phasenwinkel von 120° aufweisen. In den USA aber auch in Kanada, Australien und Großbritannien sind Haushaltsnetze oft als Einphasen-Dreileiternetze aufgebaut, bei welchen einer der drei Leiter geerdet ist und die anderen beiden unter einer gegenseitigen Phasenverschiebung von 180° jeweils z.B. 120V Wechselspannung führen. Das in Fig. 1 dargestellte Versorgungsnetz 2 kann eine beliebige dieser oder andere Netzformen haben. Jedenfalls sind der Neutralleiter N und der Schutzleiter PE an einen Anlagenerder E des Haushaltsnetzes 1 angeschlossen. Dabei können die drei in Fig. 1 dargestellten Leitungszweige Lᵢ des Haushaltsnetzes 1 jeweils ein und derselben Netzphase oder zwei oder drei verschiedenen Netzphasen zugehören und in der Folge gegeneinander entsprechend phasenverschoben sein oder nicht.

Im Beispiel der Fig. 1 sind der Neutralleiter N und der Schutzleiter PE als ein gemeinsamer Leiter ("PEN-Leiter") PEN vom Versorgungsnetztransformator zum Haushaltsnetz geführt und dort über den Anlagenerder E geerdet, wie dies bei sogenannten TN-C-S-System in Europa üblich ist. Alternativ könnte das Haushaltsnetz 1, wie dies in den USA üblich ist, die Erdung des haushaltsnaher Mast-Transformators als Anlagenerder E nutzen, an welchem sowohl der Neutralleiter N als auch der Schutzleiter PE (in Europa: für "protective earth", in den USA: "ground") über Erde mit der Energiequelle des Versorgungsnetzes 2 verbunden ist. Auch für andere Netzformen, bei welchen der Neutralleiter N und der Schutzleiter PE an einem Anlagenerder E des Haushaltsnetzes 1 kurzgeschlossen sind, sind geeignet.

Das Beispiel der Fig. 1 zeigt ein weiteres Haushaltsnetz 3, z.B. eines zweiten Haushalts in einem Mehrfamilienhaus. Das weitere Haushaltsnetz 3 gleicht dem zuvor beschriebenen Haushaltsnetz 1 weitgehend, könnte jedoch alternativ wesentlich umfangreicher oder auch einfacher in seiner Struktur sein als das Haushaltsnetz 1. Darauf wird weiter unten näher eingegangen.

Im Allgemeinen wird die elektrische Leistungsaufnahme in jedem mit einem Versorgungsnetz 2 verbundenen Haushaltsnetz 1, 3 mithilfe eines Stromzählers - z.B. eines "Smart Meters" - ermittelt (nicht dargestellt), der dem jeweiligen Haushaltsnetz 1, 3 vorgeschaltet ist, um die gesamte, von allen Verbrauchern Rᵢ dieses Haushaltsnetzes 1, 3 jeweils aufgenommene elektrische Leistung zu messen und über die Zeit zu einer verbrauchten Energie aufzusummieren bzw. -integrieren. Da diese Stromzähler der Energieabrechnung dienen, werden sie meist vom Energieversorger oder Netzbetreiber betrieben, sodass die Messdaten für den Haushalt nicht zugänglich sind.

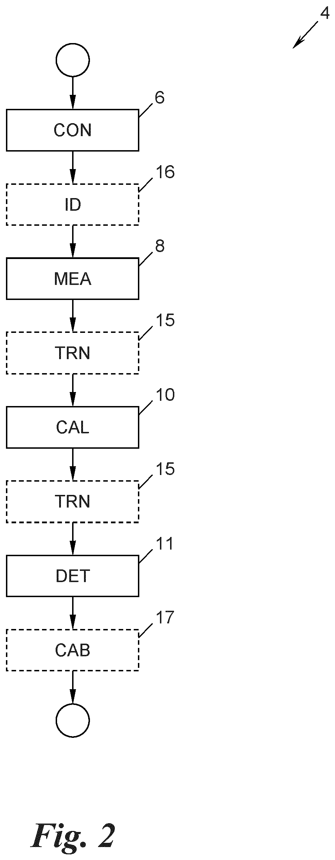

Anhand der in den Fig. 2 bis 5 dargestellten Beispiele soll daher in weiterer Folge ein Verfahren 4 zum Ermitteln der elektrischen Leistungsaufnahme in einem mit einem Versorgungsnetz verbundenen Haushaltsnetz 1 und jeweils ein dieses Verfahren 4 ausführendes Leistungsmessgerät 5 und Messsystem erläutert werden, welche ohne Zugriff auf den Stromzähler auskommen.

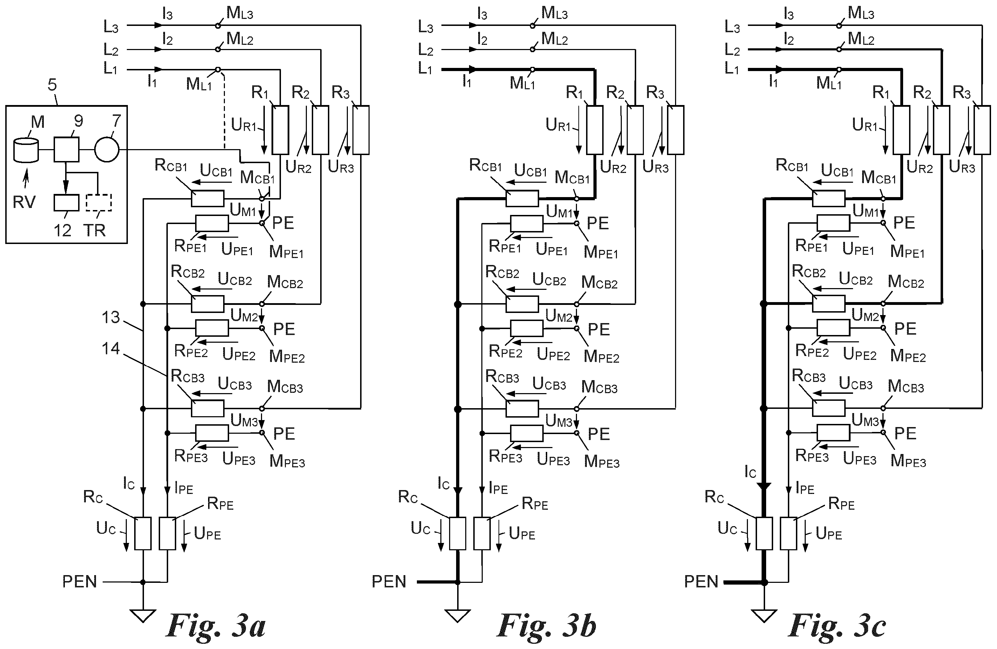

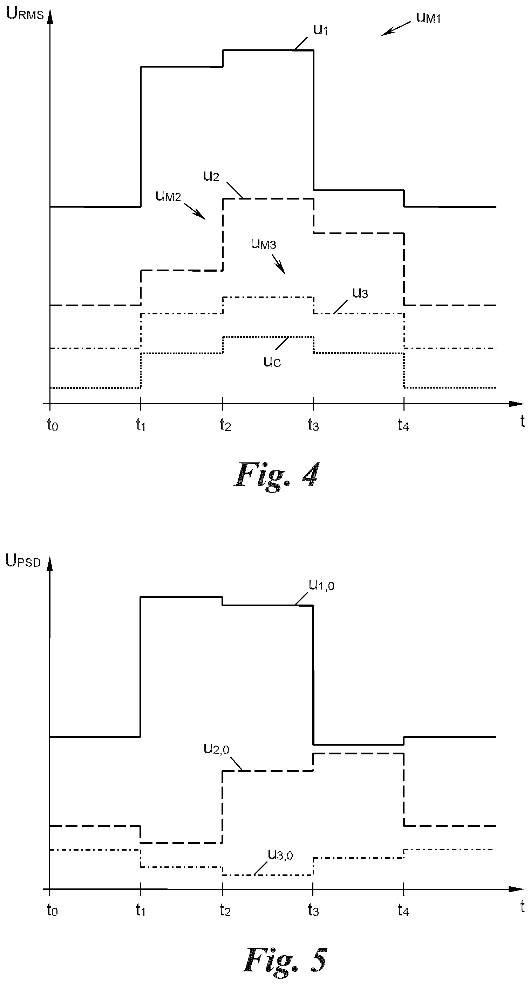

Gemäß den Fig. 2 und 3a wird in einem ersten Schritt 6 eine Spannungsmesseinheit 7 zumindest an den Neutralleiter N und den Schutzleiter PE eines der Verbraucheranschlüsse V (Fig. 1) angeschlossen, z.B. zwischen den Neutralleiter N und den Schutzleiter PE des Leitungszweigs L₁, d.h. zwischen den Kontakten M_{CB1} und M_{PE1} dieses Verbraucheranschlusses V. Darauf (Schritt 8) misst die Spannungsmesseinheit 7 an diesen Kontakten M_{CB1} und M_{PE1} einen ersten zeitlichen Verlauf u_{M1} (Fig. 4) einer elektrischen Spannung U_{M1} zwischen dem Neutralleiter N und dem Schutzleiter PE. Aus dem gemessenen ersten zeitlichen Verlauf u_{M1} errechnet eine an die Spannungsmesseinheit 7 angeschlossene Recheneinheit 9 im folgenden Schritt 10 einen Spannungswert u₁, u_{1,0} und ermittelt in weiterer Folge (Schritt 11) die elektrische Leistungsaufnahme im Haushaltsnetz 1 durch Vergleichen des errechneten Spannungswerts u₁, u_{1,0} mit zumindest einem zuvor - z.B. in einem Speicher M des Leistungsmessgeräts 5 - gespeicherten oder über z.B. einen Empfänger TR des Leistungsmessgeräts 5 von außen empfangenen Referenzwert RV.

Die Spannungsmesseinheit 7 und die Recheneinheit 9 sind beide Teil des genannten Leistungsmessgeräts 5. Das Leistungsmessgerät 5 kann die ermittelte Leistungsaufnahme an einem Display oder einer anderen Schnittstelle 12, z.B. einer Funkschnittstelle, ausgeben.

Das Verfahren 4 macht sich zunutze, dass in einem Haushaltsnetz 1, in welchem der Neutralleiter N und der Schutzleiter PE jedes Leitungszweigs Lᵢ am Anlagenerder E kurzgeschlossen sind, zwischen den beiden Kontakten M_{CB1} und M_{PE1} des Verbraucheranschlusses V nicht unerhebliche Impedanzen liegen, nämlich, wie in den Fig. 1 und 3a bis 3c gezeigt, der Reihe nach zunächst im Neutralleiterzweig 13 eine Schutzschalterleitungsimpedanz R_{CB1} vor allem infolge des Leitungswiderstandes zwischen dem Verbraucheranschluss V und dem Schaltkasten und der Impedanz des Schutzschalters selbst, eine allen Leitungszweigen Lᵢ und Netzphasen des Haushaltsnetzes 1 gemeinsame Neutralleiterimpedanz R_{C} und im Schutzleiterzweig 14 wieder eine gemeinsame Schutzleiterimpedanz R_{PE} und im Leitungszweig L₁ selbst eine spezifische Schutzleiterimpedanz R_{PE1}. Da der Strom I_{PE} im Schutzleiter PE, nämlich sowohl im einzelnen Leitungszweig Lᵢ als auch im für alle Leitungszweige Lᵢ (und Netzphasen) gemeinsamen Teil des Schutzleiters PE, im fehlerfreien Fall gleich null (oder zumindest äußerst gering) ist, sind die Beiträge der dort abfallenden Spannungen U_{PE} und U_{PE1} zum gemessenen ersten zeitlichen Verlauf der Spannung U_{M1} ebenfalls gering. Da ferner die Leitungsquerschnitte in jenem Teil des Neutralleiterzweigs 13, der dem Schaltkasten nachgelagert und allen Leitungszweigen Lᵢ (und Netzphasen) gemeinsam ist, im Allgemeinen wesentlich größer ist als der Leitungsquerschnitt der einzelnen Leitungszweige Lᵢ, nämlich typisch um zumindest einen Faktor vier (wobei der Leitungswiderstand quadratisch eingeht, also typisch um zumindest einen Faktor sechzehn kleiner ist), geht auch die Spannung U_{C} im gemeinsamen Teil des Neutralleiterzweigs 13 nur geringfügig ein, sodass im gemessenen ersten zeitlichen Verlauf der Spannung U_{M1} der Einfluss der Schutzschalterleitungsimpedanz R_{CB1} und somit der Spannung U_{CB1} dominiert.

Da über die Schutzschalterleitungsimpedanz R_{CB1} der Strom I₁ des ersten Leitungszweigs L₁ fließt, ist die daran abfallende Spannung U_{CB1} direkt proportional zur Leistungsaufnahme des Verbrauchers R₁. Der genannte Referenzwert RV ist somit ein der Schutzschalterleitungsimpedanz R_{CB1} - optional zusammen mit den weiteren Impedanzen, nämlich der gemeinsamen Neutralleiterimpedanz R_{C}, der gemeinsamen und der spezifischen Schutzleiterimpedanz R_{PE}, R_{PE1} - proportionaler Wert.

Das vorstehenden Ausführungen gelten gleichermaßen für die weiteren Leitungszweige L₂, L₃ und deren jeweilige Verbraucheranschlüsse V. Mit anderen Worten kann das Leistungsmessgerät an jeden Verbraucheranschluss V jedes der Leitungszweige Lᵢ angeschlossen werden und misst dort jeweils den ersten zeitlichen Verlauf u_{M1}, u_{M2}, u_{M3}, ..., allgemein u_{Mi}, der Spannung U_{M1,} U_{M2}, U_{M3}, ..., allgemein U_{Mi}, zwischen dem jeweiligen Neutralleiter N und dem jeweiligen Schutzleiter PE, nämlich die Spannungen U_{CB1}, U_{CB2}, ..., allgemein U_{CBi}, U_{C}, U_{PE}, sowie U_{PE1}, U_{PE2}, ..., allgemein U_{P-Ei}, an den jeweiligen Impedanzen R_{CB1}, R_{CB2}, ..., allgemein R_{CBi}, R_{C}, R_{PE}, sowie R_{PE1}, R_{PE2}, ..., allgemein R_{PEi.} Es versteht sich, dass die Impedanzen Rᵢ, R_{CBi}, R_{C}, R_{PE} und R_{PEi} im Allgemeinen nicht rein ohmsche Widerstände sondern komplexwertige Impedanzen sind.

Auch für die in Fig. 1 dargestellten beiden Haushaltsnetzwerke 1, 3 gilt, dass der Leitungsquerschnitt jener Leitungsteile, die beiden Haushaltsnetzen 1, 3 gemeinsam sind, wesentlich größer ist als alle Leitungsquerschnitte der einzelnen Haushaltsnetze 1, 3, sodass auch die gemeinsamen Impedanzen R_{Ch} und R_{PEH} wesentlich geringer als insbesondere die Schutzleiterimpedanz R_{CBi} im jeweiligen Leitungszweig Lᵢ des jeweiligen Haushaltsnetzes 1, 3 und folglich noch wesentlich geringeren Einfluss auf die Spannungen U_{Mi} haben.

Der in Schritt 10 des Verfahrens 4 errechnete Spannungswert uᵢ, u_{i,0} kann entweder ein Augenblickswert, z.B. der Scheitelwert der Spannung U_{Mi} sein, oder ein kumulierter Wert. In einer möglichen Variante des Verfahrens 4 ist der errechnete Spannungswert der Effektivwert u₁ des gemessenen ersten Verlaufs u_{Mi} der Spannung U_{Mi} oder der Gleichrichtwert. Der errechnete Spannungswert u₁, u_{1,0} kann auch mehrere Einzelgrößen umfassen, z.B. den Effektivwert u₁, den Gleichrichtwert, den Scheitelwert und/oder weitere Größen.

In einer Ausführungsform des Verfahrens 4 wird im genannten Schritt 6 des Anschließens die Spannungsmesseinheit 7 nicht nur an den Neutralleiter N und den Schutzleiter PE des Verbraucheranschlusses V angeschlossen sondern auch an den Außenleiter A dieses Verbraucheranschlusses V. Darauf wird im genannten Schritt 8 des Messens ferner ein zweiter zeitlicher Verlauf einer elektrischen Spannung U_{Ri} zwischen dem Außenleiter A und dem Neutralleiter N mit der Spannungsmesseinheit 5 gemessen. Der in Schritt 10 errechnete Spannungswert u_{1,0} ist in dieser Ausführungsform ein mit der Frequenz und der Phasenlage der elektrischen Spannung U_{Ri} zwischen dem Außenleiter A und dem Neutralleiter N modulierter Integralwert des gemessenen ersten zeitlichen Verlaufs oder umfasst diesen Integralwert. Mathematisch betrachtet handelt es sich bei der Modulation um eine Faltung des ersten und zweiten zeitlichen Verlaufs, sodass der genannte modulierte Integralwert umso größer ist, je näher die Phasenlage des ersten jener des zweiten zeitlichen Verlaufs, d.h. die Phasenlage der elektrischen Spannung u_{Mi} zwischen Neutralleiter N und Schutzleiter PE jener der elektrischen Spannung U_{Ri} zwischen Außenleiter A und Neutralleiter N, ist.

Ein Beispiel für einen solchen Integralwert ist das aus der Phase Sensitive Detection bekannte "PSD-Integral", welches in Schritt 10 beispielsweise gemäß ${u}_{i , 0} \left(t\right) = \frac{1}{T} {\int }_{{t}_{S} - T}^{{t}_{S}} sin \left(2{πf}_{Li}⋅t\right) ⋅ {u}_{Mi} \left(t\right) dt$ (Gleichung 1) errechnet wird, mit:
- u_{i,0}: Integralwert des gemessenen ersten zeitlichen Verlaufs u_{Mi} der elektrischen Spannung U_{Mi} zwischen dem Neutralleiter N und dem Schutzleiter PE für jene Netzphase des Haushaltsnetzes 1, in welcher der Leitungszweig Lᵢ mit dem Verbraucheranschluss V liegt, an welchen die Spannungsmesseinheit 7 angeschlossen ist;
- i: Leitungszweig Lᵢ mit dem Verbraucheranschluss V, an welchen die Spannungsmesseinheit 7 angeschlossen ist;
- t_{S}: Zeitpunkt des Endes der Messung;
- T: Zeitspanne der Messung; und
- f_{Li}: Frequenz der Spannung U_{Ri} zwischen dem Außenleiter A und dem Neutralleiter N im genannten Leitungszweig Lᵢ.

Wie der Fachperson bekannt ist, kann dieses Integral gleichermaßen mit Cosinus anstelle des Sinus aufgestellt werden; diese Cosinus-Variante ist somit von Gleichung 1 mitumfasst. Überdies kann das Integral, wenn die Messung in Schritt 8 diskret als Folge von Abtastpunkten und nicht kontinuierlich erfolgt, als Summe angesetzt werden, wie der Fachperson bekannt und von Gleichung 1 ebenfalls mitumfasst ist.

Anhand der Fig. 3a bis 3c in Verbindung mit Fig. 4 oder Fig. 5 soll im Folgenden das Ermitteln der Leistungsaufnahme im Haushaltsnetz 1 in verschiedenen Varianten erläutert werden.

Im Beispiel der Fig. 4 liegen die drei Leitungszweige Lᵢ an ein und derselben Netzphase, wie dies optional möglich ist. In einem ersten Zeitraum zwischen den Zeitpunkten t₀ und t₁ in Fig. 4 sind in den drei Leitungszweigen Lᵢ des Beispiels der Fig. 3a bis 3c keine Verbraucher Rᵢ angeschlossen bzw. sind diese ausgeschaltet, siehe Fig. 3a. Folglich fließt in keinem der drei Leitungszweige Lᵢ (nennenswerter) Strom Iᵢ. Die im Diagramm der Fig. 4 dargestellten Spannungen u₁, u₂, u₃ bzw. u_{C} dienen der Illustration und entsprechen beispielhaft jeweils Effektivwerten uᵢ ("U_{RMS}") der gemessenen ersten Verläufe u_{Mi} der Spannungen U_{Mi} sowie der Spannung U_{C}, welche im beschriebenen Verfahren 4 im Allgemeinen gar nicht allesamt (und im Fall der Spannung U_{C} in keinem Fall) gemessen und errechnet werden. Die dargestellten Spannungen uᵢ und u_{c} sind ferner in Richtung der Ordinate gegeneinander verschoben, sodass die Ordinate für jede davon einen unterschiedlichen Nullpunkt hat, nämlich jeweils an der Stelle des Zeitraums zwischen den Zeitpunkten t₀ und t₁.

Wie in Fig. 3b durch die fette Linie symbolisiert, wird im Zeitpunkt t₁ ein leistungsstarker Verbraucher R₁ in Leitungszweig L₁ zugeschaltet bzw. angeschlossen. Infolgedessen steigt der Strom I₁ im Leitungszweig L₁ sprunghaft an, sodass auch die Spannung u₁ sprunghaft ansteigt, da der Strom I₁ über die Impedanzen R_{CB1} und R_{C} und den Neutralleiter N (hier: PEN) fließt. Aus demselben Grund steigt auch die Spannung u_{C} an der allen drei Leitungszweigen Lᵢ gemeinsamen Impedanz R_{C}, wobei dieser Anstieg in Fig. 4 zur besseren Erkennbarkeit größer dargestellt ist, als dies in einem üblichen Haushaltsnetz 1 zu erwarten ist. Wie in Fig. 4 zu erkennen ist, steigen gleichzeitig die beiden Spannungen u₂ und u₃ in den beiden anderen Leitungskreisen L₂ und L₃ um den Betrag der Spannung u_{C}, da ihr Verlauf zwischen den Kontakten M_{CB2} und M_{PE2} bzw. M_{CB3} und M_{PE3} mitgemessen wurde.

Obwohl in den beiden Leitungszweigen L₂ und L₃ bis zum Zeitpunkt t₂ kein Strom über die Verbraucher R₂ oder R₃ fließt, könnte auf der Grundlage einer oder beider Spannungen u₂ und u₃ anhand der gemeinsamen Impedanz R_{C} dennoch der Verbrauch im Leitungszweig L₁ ermittelt werden. Dazu muss nur ausgeschlossen werden, dass der Sprung in z.B. der Spannung u₂ im zweiten Leitungszweig L₂ von einem (stärkeren) Verbraucher R₁, R₃ in einem anderen Leitungszweig L₁, L₃ und nicht von einem schwächeren Verbraucher R₂ im eigenen Leitungskreis L₂ hervorgerufen wird. Dies lässt sich beispielsweise dadurch ausschließen, dass im genannten Schritt 6 des Anschließens an den Neutralleiter N und den Schutzleiter PE zumindest zweier in verschiedenen Leitungszweigen Lᵢ des Haushaltsnetzes 1 liegender Verbraucheranschlüsse V jeweils die Spannungsmesseinheiten 7 zweier verschiedener kooperierender, ein Messsystem bildender Leistungsmessgeräte 5 angeschlossen wird, wie im Anschluss näher erläutert wird.

Zurückkommen auf die Fig. 3c und 4 wird im Zeitpunkt t₂ ein mittelgroßer Verbraucher R₂ im Leitungszweig L₂ zugeschaltet - symbolisiert durch eine mittelfette Linie in Fig. 3c. Nun springt die Spannung u₂ auf einen deutlich höheren Wert und die Spannungen u₁ und u₃ um etwa die Sprunghöhe der Spannung u_{C}. Im Zeitpunkt t₃ wird der Verbraucher R₁ im ersten Leitungszweig L₁ wieder deaktiviert; alle Spannungen u₁ und u_{C} fallen jeweils um den Betrag, um welchen sie im Zeitpunkt t₁ angestiegen sind. Schließlich wird im Zeitpunkt t₄ auch der Verbraucher R₂ im zweiten Leitungszweig L₂ abgeschaltet, sodass alle Spannungen uᵢ und u_{C} wieder auf ihren Anfangszustand fallen.

Wird das vorgenannte Messsystem aus zumindest zwei kooperierenden Leistungsmessgeräten 5 (nicht dargestellt) verwendet, misst jede Spannungsmesseinheit 7 in Schritt 8 den ersten zeitlichen Verlauf u_{Mi} der elektrischen Spannung U_{Mi} zwischen dem Neutralleiter N und dem Schutzleiter PE ihres Leitungszweiges Lᵢ. Zumindest eines der beiden Leistungsmessgeräte 5 hat dabei einen Sender (im Beispiel der Fig. 3a: einen kombinierten Sendeempfänger TR) und das andere der beiden Leistungsmessgeräte 5 einen Empfänger TR. In einem in dieser Ausführungsvariante zusätzlichen Schritt 15 (Fig. 2) überträgt das eine Leistungsmessgerät 5 über seinen Sender TR entweder den von seiner Spannungsmesseinheit 7 gemessenen ersten zeitlichen Verlauf u_{Mi} oder den von seiner Recheneinheit 9 aus dem gemessenen ersten zeitlichen Verlauf u_{Mi} errechneten Spannungswert uᵢ, u_{i,0}, deshalb kann Schritt 15 vor oder nach Schritt 10 des Errechnens ausgeführt werden und ist in Fig. 4 an beiden Stellen gezeigt. Diese Sendung empfängt das andere Leistungsmessgeräte 5 über seinen Empfänger TR in seiner Recheneinheit 9 in Schritt 15 des Übertragens. In demselben Schritt 15 überträgt ferner die Spannungsmesseinheit 7 des anderen Leistungsmessgeräts 5 den von ihr gemessenen ersten zeitlichen Verlauf u_{Mi} - hier: innerhalb des anderen Leistungsmessgeräts 5 - ebenfalls an seine Recheneinheit 9. Die Recheneinheit 9 des genannten anderen Leistungsmessgeräts 5 bildet in dieser Variante eine zentrale Recheneinheit 9 für beide Leistungsmessgeräte 5 des Messsystems, da sie in weiterer Folge die genannten Schritte 10 und 11 des Errechnens und Ermittelns anhand des/der übertragenen ersten zeitlichen Verlaufs/Verläufe und anhand der übertragenen und/oder errechneten Spannungswerte ausführt.

Schritt 15 ist in Fig. 2 strichliert dargestellt, um zu versinnbildlichen, dass er optional ist.

Auf diese Weise ermittelt die zentrale Recheneinheit 9 mithilfe lediglich zweier Spannungsmesseinheiten 7, die an den Neutralleiter N und den Schutzleiter PE jeweils eines von zwei Verbraucheranschlüssen V in verschiedenen Leitungszweigen Lᵢ des Haushaltsnetzes 1 angeschlossen sind, die Leistungsaufnahme im gesamten Haushaltsnetz 1 der Fig. 3a bis 3c: Springt der errechnete Spannungswert uᵢ in einem Zeitpunkt in den beiden Leitungszweigen Lᵢ, an welchen gemessen wird, etwa gleich stark, dann wurde ein Verbraucher Rᵢ im dritten Leitungszweig Lᵢ zugeschaltet und die Leistungsaufnahme lässt sich anhand des entsprechenden Referenzwerts RV ermitteln, welcher im Wesentlichen die Wirkung der Impedanz R_{C} berücksichtigt; dies gilt z.B. im Zeitpunkt t₁ für die Leitungszweige L₂ und L₃. Springt hingegen der errechnete Spannungswert uᵢ in einem Zeitpunkt in den beiden Leitungszweigen Lᵢ, an welchen gemessen wird, verschieden stark, so wurde ein Verbraucher Rᵢ in jenem Leitungszweig Lᵢ zugeschaltet, in welchem der errechnete Spannungswert uᵢ stärker gesprungen ist, und die Leistungsaufnahme lässt sich anhand des entsprechenden Referenzwerts RV ermitteln, der die Impedanzen R_{CBi} in diesem Leitungszweig Lᵢ und R_{C} berücksichtigt; dies gilt z.B. im Zeitpunkt t₂ für die Leitungszweige L₂ und L₃. Dies gilt für negative und positive Sprünge gleichermaßen und für andere Ausführungsformen des Verfahrens 4 mit anders errechneten Spannungswerten uᵢ.

Auch die Darstellung in Fig. 5 dient wie jene in Fig. 4 zunächst der Illustration, da gemäß dem Verfahren 4 nicht alle drei dargestellten Spannungswerte u_{1,0}, u_{2,0}, u_{3,0} errechnet würden. Diese Darstellung unterscheidet sich von der in Fig. 4 gezeigten Variante dadurch, dass die betrachteten Leitungszweige Lᵢ in den drei um jeweils 120° gegeneinander versetzten Netzphasen eines dreiphasigen Haushaltsnetzes 1 liegen und das Diagramm auf PSD-Integrale ("U_{PSD}") bezogen ist. Unter dieser Prämisse kann das Ermitteln der Leistungsaufnahme im Haushaltsnetz 1 wieder anhand der Fig. 3a bis 3c erläutert werden.

Wieder sind im ersten Zeitraum zwischen den Zeitpunkten t₀ und t₁ in Fig. 5 in den drei Leitungszweigen Lᵢ keine Verbraucher Rᵢ angeschlossen bzw. sind diese ausgeschaltet, siehe Fig. 3a, und sind die drei in Fig. 5 entlang der Ordinate gegeneinander verschobenen errechneten Spannungswerte u_{1,0}, u_{2,0}, u_{3,0} deshalb etwa gleich null.

Im Zeitpunkt t₁ wird wieder der leistungsstarke Verbraucher R₁ im Leitungszweig L₁ (und damit in der ersten Netzphase) zugeschaltet, was sich in einem Spannungssprung im Verlauf der errechneten Spannung u_{1,0} niederschlägt, wie zuvor ähnlich unter Bezugnahme auf Fig. 4 erläutert wurde. Im Gegensatz dazu ergibt dieser Spannungssprung für den errechneten Spannungswert u_{2,0} in der um 120° versetzten Netzphase des zweiten Leitungszweigs L₂ einen - im Vergleich zur Variante der Fig. 4 noch kleineren - Sprung in negativer Richtung, da gilt: cos 120° = -0,5, d.h. der Spannungssprung ist (bei rein ohmschen Verbrauchern Rᵢ) halb so groß wie im Beispiel der Fig. 4. Dasselbe gilt wegen cos 240° = -0,5 auch für den errechneten Spannungswert u_{3,0} in der um 240° versetzten Netzphase des dritten Leitungszweigs L₃.

Wird darauf gemäß Fig. 3c im zweiten Leitungszweig L₂ der mittelstarke Verbraucher R₂ zugeschaltet, schlägt sich dies in einem mittelgroßen (positiven) Sprung im errechneten Spannungswert u_{2,0} nieder, wogegen die beiden anderen errechneten Spannungswerte u_{1,0} und u_{3,0} einen wesentlich kleineren negativen Spannungssprung zeigen (Fig. 5). Dasselbe gilt umgekehrt für das Abschalten der Verbraucher R₁ bzw. R₂ jeweils in den Zeitpunkten t₃ und t₄.

Wird also ein Verbraucher Rᵢ in derselben Netzphase aktiviert, in welcher der Verbraucheranschluss V liegt, an welchen die Spannungsmesseinheit 7 angeschlossen ist, dann schlägt sich die zusätzliche Leistungsaufnahme als positiver Sprung im errechneten Spannungswert u_{i,0} nieder. Wird hingegen ein Verbraucher Rᵢ in einer anderen Netzphase aktiviert, so wird der Spannungssprung negativ sein, sodass die Netzphase des zugeschalteten Verbrauchers Rᵢ bereits anhand des Richtung des Spannungssprungs erkennbar ist.

Dies gilt in ähnlicher Weise für den Fall, dass das Haushaltsnetz 1 der Fig. 3a bis 3c ein Einphasen-Dreileiternetz wäre, in welchem z.B. die beiden Leitungszweige L₁ und L₂ an denselben Außenleiter A (gleichsam: dieselbe Phase) und der Leitungszweig L₃ an den anderen Außenleiter A (gleichsam die um 180° verschobene Gegenphase) angeschlossen sind. Dabei würde sich der Sprung des errechneten Spannungswerts u_{1,0} im Zeitpunkt t₁ (bei rein ohmschen Verbrauchern Rᵢ) im zweiten Leitungszweig L₂ in einem im Wesentlichen um das Verhältnis R_{C}/(R_{CB1}+R_{C}) verringerten (positiven) Sprung des Spannungswerts u_{2,0} niederschlagen (nicht dargestellt) und im Leitungszweig L₃ in einem um im Wesentlichen dasselbe Verhältnis jedoch infolge der 180°-Verschiebung negativen Sprung des Spannungswerts u_{3,0}, wegen cos 180° = -1. Allerdings könnte alleine daraus nicht unmittelbar geschlossen werden, ob die geringfügige Verringerung z.B. des Spannungswerts u_{2,0} die Folge des Abschaltens eines Verbrauchers R₃ im Leitungszweig L₃ selbst oder, wie in den Fig. 3c und 5 für den Zeitpunkt t₂ gezeigt, die Folge des Zuschaltens z.B. eines (leistungsstärkeren) Verbrauchers R₂ im Leitungszweig L₂ ist. Um diesen Schluss ziehen zu können, kann in diesem Fall verglichen werden, wie sich in diesem Zeitpunkt (hier: t₂) die Spannung U_{R3} am Verbraucher R₃, d.h. zwischen Außenleiter A und Neutralleiter N des Leitungszweigs L₃, im Vergleich zur Spannung U_{M3} zwischen Neutralleiter N und Schutzleiter (hier: "ground") PE verändert: Ändert sich in einem ersten Fall (i) die Spannung U_{R3} am Verbraucher R₃ nicht signifikant, während die Spannung U_{M3} zwischen Neutralleiter N und Schutzleiter PE ansteigt bzw. sinkt, zeigt dies ein Abschalten bzw. Zuschalten eines Verbrauchers Rᵢ in einem Leitungszweig Lᵢ der Gegenphase an. Steigt in einem zweiten Fall (ii) die Spannung U_{M3} zwischen Neutralleiter N und Schutzleiter PE an und sinkt zugleich die Spannung U_{R3} am Verbraucher R₃ im selben Leitungszweig L₃, dann wurde in diesem Leitungszweig L₃ ein Verbraucher R₃ zugeschaltet. Sinkt schließlich in einem dritten Fall (iii) die Spannung U_{M3} zwischen Neutralleiter N und Schutzleiter PE und steigt zugleich die Spannung U_{R3} am Verbraucher R₃ im selben Leitungszweig L₃ an, dann wurde in diesem Leitungszweig L₃ ein Verbraucher R₃ abgeschaltet. Dasselbe gilt entsprechend für die anderen Leistungszweige Lᵢ und umgekehrt für negative Verbraucher Rᵢ, d.h. Einspeiseeinheiten.

Die in den Fig. 4 und 5 dargestellten errechneten Spannungswerte uᵢ, u_{i,0} sind zur einfacheren Erkennbarkeit wesentlich idealisiert. In Realität ergeben sich durch Rauschen, Einschwingvorgänge, induktive und/oder kapazitive Verbraucher Rᵢ etc. der gemessenen zeitlichen Verläufe u_{Mi} der Spannungen u_{Mi} auch für die errechneten Spannungswerte uᵢ, u_{i,0} deutlich ungleichmäßigere Zeitverläufe.

Da ja im Gegensatz zur Illustration in Fig. 5 im eigentlichen Verfahren 4 nicht für alle Leitungszweige Lᵢ bzw. Netzphasen zeitlichen Verläufe u_{Mi} der Spannungen U_{Mi} gemessen werden, wird zum Ermitteln der Leistungsaufnahme optional im genannten Schritt 10 des Errechnens der Integralwert für jede Netzphase und daraus für jede Netzphase ein eigener Spannungswert u_{i,0}, u_{i,120}, u_{i,240} mit zugehörigem Phasenwinkel gegenüber dieser Netzphase errechnet, z.B. gemäß Gleichung 1 und ${u}_{i , 120} \left(t\right) = \frac{1}{T} {\int }_{{t}_{S} - T}^{{t}_{S}} sin \left(2{πf}_{Li}⋅t+120°\right) ⋅ {u}_{Mi} \left(t\right) dt$ (Gleichung 2a) bzw. ${u}_{i , 120} \left(t\right) = \frac{1}{T} {\int }_{{t}_{S} - T}^{{t}_{S}} sin \left(2{πf}_{Li}⋅t+\frac{2 π}{3}\right) ⋅ {u}_{Mi} \left(t\right) dt$ (Gleichung 2b) und ${u}_{i , 240} \left(t\right) = \frac{1}{T} {\int }_{{t}_{S} - T}^{{t}_{S}} sin \left(2{πf}_{Li}⋅t+240°\right) ⋅ {u}_{Mi} \left(t\right) dt$ (Gleichung 3a) bzw. ${u}_{i , 240} \left(t\right) = \frac{1}{T} {\int }_{{t}_{s} - T}^{{t}_{s}} sin \left(2{πf}_{Li}⋅t+\frac{4 π}{3}\right) ⋅ {u}_{Mi} \left(t\right) dt$ (Gleichung 3b) jeweils mit:
u_{i,120} Integralwert des gemessenen ersten zeitlichen Verlaufs u_{Mi} für die gegenüber jener Netzphase des Haushaltsnetzes 1, in welcher der Leitungszweig Lᵢ mit dem Verbraucheranschluss V liegt, an welchen die Spannungsmesseinheit 7 angeschlossen ist, um 120° (bzw. 2π/3) verschobene Netzphase; und
u_{i,240} Integralwert des gemessenen ersten zeitlichen Verlaufs u_{Mi} für die gegenüber jener Netzphase des Haushaltsnetzes 1, in welcher der Leitungszweig Lᵢ mit dem Verbraucheranschluss V liegt, an welchen die Spannungsmesseinheit 7 angeschlossen ist, um 240° (bzw. 4π/3) verschobene Netzphase.

Daraus lässt sich der Phasenwinkel φᵢ gegenüber der Phasenlage der jeweils gemessenen Netzphase z.B. bestimmen gemäß: ${φ}_{i} = arctan \left(\frac{{Q}_{i}}{{I}_{i}}\right)$ (Gleichung 4) mit: ${I}_{i} = \frac{2}{3} \left({u}_{i , 0}-\frac{1}{2}⋅{u}_{i , 120}-\frac{1}{2}⋅{u}_{i , 240}\right) ,$ und ${Q}_{i} = \frac{1}{\sqrt{3}} \left({u}_{i , 120}-{u}_{i , 240}\right) .$

Im genannten Schritt 11 des Ermittelns wird darauf die elektrische Leistungsaufnahme in jeder Netzphase des Haushaltsnetzes 1 durch Vergleichen der für jede Netzphase Lᵢ errechneten Spannungswerte u_{i,0}, u_{i,120}, u_{i,240} mit den jeweils für diese Netzphase gespeicherten Referenzwerten RV ermittelt. Liegt also beispielsweise der Phasenwinkel φᵢ nahe bei 120° gegenüber der Netzphase des Leitungszweiges Lᵢ mit dem Verbraucheranschluss V, an welchen die Spannungsmesseinheit 7 angeschlossen ist, wird davon ausgegangen, dass der Verbraucher Rᵢ in einem Leitungszweig Lᵢ angeschlossen wurde, der in jener Netzphase liegt, die um 120° gegenüber derjenigen verschoben ist, in welcher Spannungsmesseinheit 7 gemessen hat. Dabei wurde in keinem Leitungszweig Lᵢ jener Netzphase gemessen. Daraus lässt sich mithilfe des zumindest einen Referenzwerts RV die Leistungsaufnahme in den Leitungszweigen Lᵢ jeder Netzphase ermitteln. Die errechneten Spannungswerte u_{i,120} und u_{i,240} entsprechen dabei den im Verfahren 4 mangels Messung nicht errechneten Spannungswerten u_{2,0} und u_{3,0} der Fig. 5 und bilden diese im Verfahren 4 sehr gut ab.

Anstatt dass der zumindest eine Referenzwert RV gespeichert ist, kann dieser z.B. über den Sendeempfänger TR von außen, d.h. von einem vom Leistungsmessgerät 5 separaten Gerät, empfangen werden, u.zw. insbesondere von einer Einspeiseeinheit (nicht dargestellt), z.B. von einer Photovoltaikanlage, die an denselben oder einen anderen Leitungszweig Lᵢ angeschlossen ist wie das Leistungsmessgerät 5. In dieser Ausführungsform sendet die Einspeiseeinheit ihre aktuelle Einspeiseleistung an das Leistungsmessgerät 5, dessen Recheneinheit 9 den empfangenen Wert als Referenzwert RV verwendet. Dabei kann optional die Einspeiseleistung gesteuert oder sogar in einem geschlossenen Regelkreis geregelt werden, bei welchem die Leistungsaufnahme im Haushaltsnetz 1, d.h. der Verbrauch aller Verbraucher Rᵢ abzüglich der Einspeiseleistung der Einspeiseeinheit, möglichst gering sein soll. Als Regelgröße dient in diesem Fall beispielsweise die errechnete Spannung uᵢ, u_{i,0}, die, wenn die Spannungsmesseinheit 7 an denselben Leitungszweig Lᵢ wie die Einspeiseeinheit angeschlossen ist, möglichst gleich null sein soll. Ist die Einspeiseeinheit an einen anderen Leitungszweig Lᵢ als die Spannungsmesseinheit 7 angeschlossen, kann das hierin beschriebene Prinzip gleichartig angewandt werden, indem die Einspeiseeinheit als negativer Verbraucher Rᵢ eingeht.

Die vorangehenden Betrachtungen gingen davon aus, dass sowohl die Verbraucher Rᵢ als auch die anderen Impedanzen R_{CBi}, R_{C}, R_{PE}, R_{PEi} zumindest im Wesentlichen ohmsche Impedanzen sind. Wäre z.B. einer der Verbraucher Rᵢ im Wesentlichen induktiv oder kapazitiv, sodass der Phasenwinkel gegenüber der zugehörigen Netzphase annähernd -90° oder 90° betrüge, was die Zuordnung zur richtigen Netzphase erschwert. Da jedoch im Allgemeinen leistungsstarke Verbraucher Rᵢ zumindest überwiegend ohmsch sind, kann man jene Verbraucheranteile, die einen Phasenwinkel von beispielsweise weniger als -45°, -40°, -35° oder -30° oder mehr als 30°, 35°, 40° oder 45° haben, im Schritt 10 des Errechnens des Spannungswerts uᵢ, u_{i,0} außer Acht lassen, sodass es zu keinen Phasenüberlappungen oder Mehrdeutigkeiten kommt.

Es versteht sich, dass anstelle der (oder zusätzlich zu den) Integralwerten, insbesondere den PSD-Integralen im genannten Schritt 10 des Errechnens für jede Netzphase ein eigener Spannungswert (nicht dargestellt) mit zugehörigem Phasenwinkel gegenüber dieser Netzphase mithilfe einer Fourier-Transformierten des gemessenen ersten zeitlichen Verlaufs errechnet werden kann, wobei im genannten Schritt 11 des Ermittelns die elektrische Leistungsaufnahme in jeder Netzphase des Haushaltsnetzes 1 ermittelt wird. Die komplexwertige Fourier-Transformierten enthält direkt Betrag und Phasenwinkel für den jeweiligen Spannungswert, sodass wie zuvor in Bezug auf die Spannungswerte u_{1,0}, u_{1,120}, u_{1,240} erläutert vorgegangen werden kann. Die Fourier-Transformierte wird beispielsweise mithilfe der schnellen Fourier-Transformationsalgorithmus ("fast fourier transform", FFT-Algorithmus) gebildet. Die Fourier-Transformierte kann optional gefiltert werden, indem jene Frequenzanteile, die von der Netzfrequenz (z.B. 50 Hz bzw. 60 Hz) deutlich abliegen, z.B. mehr als +/- 1 Hz, +/- 2 Hz oder +/- 4Hz etc., nicht weiter berücksichtigt werden.

An sich kann der genannte erste (und, wo erforderlich, ebenso der zweite) zeitliche Verlauf u_{Mi} über eine beliebige Zeitspanne gemessen werden. Optional wird der genannte Schritt 8 des Messens über eine Zeitspanne von ein, zwei, drei, vier oder mehr ganzen Netzperioden durchgeführt. Die Messung kann dabei in jedem beliebigen Zeitpunkt der Netzperiode beginnen, z.B. mit einem Nulldurchgang des genannten zweiten zeitlichen Verlaufs der elektrischen Spannung U_{Ri} zwischen dem Außenleiter A und dem Neutralleiter N des Verbraucheranschlusses V, an welchen die Spannungsmesseinheit 7 des Leistungsmessgeräts 5 angeschlossen ist, insbesondere einem Nulldurchgang von negativer zu positiver Spannung. Das Messen über ganze Netzperioden erleichtert das Errechnen des Spannungswerts uᵢ, u_{i,0}; je mehr ganze Netzperioden die Zeitspanne umfasst, desto genauer wird der errechnete Spannungswert uᵢ, u_{i,0}, jedoch werden Änderungen infolge des Zu- und Abschaltens von Verbrauchern Rᵢ langsamer erfasst.

Mit dem beschriebenen Verfahren 4 kann die Leistungsaufnahme im Haushaltsnetz 1 anhand der errechneten Spannungswerte uᵢ, u_{i,0} mit guter Genauigkeit ermittelt werden. Da sich in einem z.B. dreiphasigen Haushaltsnetz 1 in dem seltenen Fall, dass in allen drei Phasen gleich starke Verbraucher Rᵢ zugeschaltet sind, die Teilströme des Stroms I_{C} im gemeinsamen Teil des Neutralleiterzweigs 13 aufheben, erschiene die tatsächliche Leistungsaufnahme pro Netzphase jedoch geringer, da die Spannung U_{C} im gemeinsamen Teil des Neutralleiterzweigs 13 gleich null wäre. In abgeschwächter Form gilt dies auch, wenn sich die Teilströme des Stroms I_{C} im gemeinsamen Teil des Neutralleiters N nicht ganz aufheben.

Da gleichzeitiges Zu- oder Abschalten von Verbrauchern Rᵢ in allen Leitungszweigen Lᵢ, d.h. auch allen Netzphasen, äußerst unwahrscheinlich ist, kann dem vorgebeugt werden, indem das Verfahren 4 nicht nur - wie im Allgemeinen vorgesehen - wiederholt ausgeführt wird, sondern indem optional auch im genannten Schritt 10 des Errechnens für jede Netzphase ermittelt wird, ob gegenüber der vorhergehenden Ausführungswiederholung des Verfahrens 4 ein Spannungssprung aufgetreten ist, d.h. irgendein Spannungssprung in irgendeinem Leitungszweig Lᵢ irgendeiner der Netzphasen. Ferner wird dabei im genannten Schritt 10 des Errechnens der Spannungswert uᵢ, u_{i,0} für diesen Leitungszweig Lᵢ und damit diese Netzphase durch Kombination des für diese Netzphase in der vorhergehenden Ausführungswiederholung errechneten Spannungswerts uᵢ, u_{i,0} und des ermittelten Spannungssprungs errechnet, d.h. der zuvor errechnete Spannungswert wird um den errechneten Spannungssprung - je nach Sprungrichtung - erhöht oder reduziert. Um einem langfristigen Driften des in diesem Fall stetig korrigierten Spannungswerts uᵢ, u_{i,0} entgegenzuwirken, kann eine z.B. exponentielle oder zeitabhängige Abkling-Funktion (decay-function) oder eine Korrektur bei Spannungswerten uᵢ, u_{i,0} von weniger als null oder mehr als einem durch die Leitungsschutzschalter vorgegebenen Maximalwert vorgesehen werden.

Der zumindest eine Referenzwert RV kann entweder - insbesondere in Kenntnis des Haushaltsnetzes 1 - abgeschätzt oder simuliert werden. In einer optionalen Ausführungsform umfasst das Verfahren 4 gemäß Fig. 2 ferner ein dem genannten Schritt 11 des Ermittelns vorgelagertes Bestimmen 16 des Referenzwerts RV mit den folgenden Teilschritten:
Anschließen und Einschalten eines Verbrauchers Rᵢ mit vorbekannter Leistung an den Leitungszweig Lᵢ mit dem Verbraucheranschluss V, an welchen die Spannungsmesseinheit 7 angeschlossen ist;
Messen eines ersten zeitlichen Verlaufs u_{Mi} einer elektrischen Spannung U_{Mi} zwischen dem Neutralleiter N und dem Schutzleiter PE mit der Spannungsmesseinheit 7 vor und nach dem Einschalten des Verbrauchers Rᵢ; und
Errechnen jeweils zumindest eines Spannungswerts uᵢ, u_{i,0} aus dem gemessenen ersten zeitlichen Verlauf u_{Mi} der elektrischen Spannung U_{Mi} vor und nach dem Einschalten des Verbrauchers Rᵢ und Bestimmen des Referenzwerts RV aus der Differenz der errechneten Spannungswerte uᵢ, u_{i,0} vor und nach dem Einschalten des Verbrauchers Rᵢ.

Dieser Schritt 16 des Bestimmens kann entweder völlig unabhängig von den weiteren Schritten 6, 8 und 10 durchgeführt werden; im Allgemeinen wird er jedoch nach Schritt 6 des Anschließens durchgeführt, wie in Fig. 2 gezeigt. Wieder ist durch Strichlieren des Schritts 16 versinnbildlicht, dass er optional ist.

Der zumindest eine Referenzwert RV ist im einfachsten Fall z.B. ein Verhältnis zwischen der vorbekannten Leistung des genannten elektrischen Verbrauchers Rᵢ und der errechneten Differenz. Andere, vor allem mehrere Referenzwerte RV, z.B. für unterschiedliche Verbraucher Rᵢ, in unterschiedlichen Leitungszweigen Lᵢ bzw. Netzphasen etc. können zum Ermitteln der Leistungsaufnahme im Haushaltsnetz 1 optional bestimmt werden. In diesem Zusammenhang sei angemerkt, dass das genannte Ermitteln gemäß dem Verfahren 4 im einfachsten Fall bereits dann abgeschlossen ist, wenn die Leistungsaufnahme in jenem Leitungszweig Lᵢ mit dem Verbraucheranschluss V ermittelt wurde, an welchen die Spannungsmesseinheit 7 angeschlossen ist.

Alternativ oder zusätzlich umfasst das Verfahren 4 ein begleitendes Kalibrieren 17 des zumindest einen Referenzwerts RV, wobei das Verfahren 4 ebenfalls wiederholt ausgeführt und der im genannten Schritt 10 des Errechnens errechnete Spannungswert uᵢ, u_{i,0} wiederholt mit dem zumindest einen im Speicher M gespeicherten Referenzwert RV verglichen und bei Überschreiten als zumindest ein neuer Referenzwert RV gespeichert wird.

Die Erfindung ist nicht auf die dargestellten Ausführungsformen beschränkt, sondern umfasst alle Varianten, Modifikationen und deren Kombinationen, die in den Rahmen der angeschlossenen Ansprüche fallen.

## Patentansprüche

1. Verfahren zum Ermitteln der elektrischen Leistungsaufnahme in einem mit einem Versorgungsnetz (2) verbundenen Haushaltsnetz (1), welches eine oder mehrere Netzphasen mit jeweils einem oder mehreren Leitungszweigen (Lᵢ) und in jedem Leitungszweig (Lᵢ) einen oder mehrere Verbraucheranschlüsse (V) mit jeweils einem Außenleiter (A), einem Neutralleiter (N) und einem Schutzleiter (PE) hat, wobei der Neutralleiter (N) und der Schutzleiter (PE) an einen Anlagenerder (E) des Haushaltsnetzes (1) angeschlossen sind, umfassend die Schritte:
Anschließen (6) einer Spannungsmesseinheit (7) an den Neutralleiter (N) und den Schutzleiter (PE) eines der Verbraucheranschlüsse (V);
Messen (8) eines ersten zeitlichen Verlaufs (u_{Mi}) einer elektrischen Spannung (U_{Mi}) zwischen dem Neutralleiter (N) und dem Schutzleiter (PE) mit der Spannungsmesseinheit (7);
Errechnen (10) eines Spannungswerts (uᵢ, u_{i,0}) aus dem gemessenen ersten zeitlichen Verlauf (u_{Mi}); und
Ermitteln (11) der elektrischen Leistungsaufnahme im Haushaltsnetz (1) durch Vergleichen des errechneten Spannungswerts (uᵢ, u_{i,0}) mit zumindest einem gespeicherten oder empfangenen Referenzwert (RV).

2. Verfahren nach Anspruch 1, wobei der errechnete Spannungswert (uᵢ, u_{i,0}) einen Effektivwert (uᵢ) und/oder Gleichrichtwert des gemessenen ersten zeitlichen Verlaufs (u_{Mi}) umfasst.

3. Verfahren nach Anspruch 1 oder 2, wobei im genannten Schritt (6) des Anschließens die Spannungsmesseinheit (7) ferner an den Außenleiter (A) des genannten Verbraucheranschlusses (V) angeschlossen wird, wobei im genannten Schritt (8) des Messens ferner ein zweiter zeitlicher Verlauf einer elektrischen Spannung (U_{Ri}) zwischen dem Außenleiter (A) und dem Neutralleiter (N) mit der Spannungsmesseinheit (7) gemessen wird, und wobei der errechnete Spannungswert (uᵢ, u_{i,0}) einen mit der Frequenz und der Phasenlage der elektrischen Spannung (U_{Ri}) zwischen dem Außenleiter (A) und dem Neutralleiter (N) modulierten Integralwert des gemessenen ersten zeitlichen Verlaufs (u_{Mi}) umfasst.

4. Verfahren nach Anspruch 3, wobei der Integralwert als phasenabhängiger Wert gemäß: ${u}_{i , 0} \left(t\right) = \frac{1}{T} {\int }_{{t}_{s} - T}^{{t}_{s}} sin \left(2{πf}_{Li}⋅t\right) ⋅ {u}_{Mi} \left(t\right) dt$ errechnet wird, mit:
u_{i,0} Integralwert des gemessenen ersten zeitlichen Verlaufs (u_{Mi}) der elektrischen Spannung (U_{Mi}) zwischen dem Neutralleiter (N) und dem Schutzleiter (PE) für jene Netzphase des Haushaltsnetzes (1), in welcher der Leitungszweig (Lᵢ) mit dem Verbraucheranschluss (V) liegt, an welchen die Spannungsmesseinheit (7) angeschlossen ist;
i Leitungszweig (Lᵢ) mit dem Verbraucheranschluss (V), an welchen die Spannungsmesseinheit (7) angeschlossen ist;
t_{S} Zeitpunkt des Endes der Messung;
T Zeitspanne der Messung; und
f_{Li} Frequenz der Spannung (U_{Ri}) zwischen dem Außenleiter (A) und dem Neutralleiter (N) im genannten Leitungszweig (Lᵢ).

5. Verfahren nach Anspruch 3 oder 4, wobei im genannten Schritt (10) des Errechnens der Integralwert für jede Netzphase und daraus für jede Netzphase ein eigener Spannungswert (u_{i,0}, u_{i,120}, u_{i,240}) mit zugehörigem Phasenwinkel gegenüber dieser Netzphase errechnet wird, und wobei im genannten Schritt (11) des Ermittelns die elektrische Leistungsaufnahme in jeder Netzphase des Haushaltsnetzes (1) durch Vergleichen der für jede Netzphase errechneten Spannungswerte (u_{i,0}, u_{i,120}, u_{i,240}) mit jeweils für diese Netzphase gespeicherten Referenzwerten (RV) ermittelt wird.

6. Verfahren nach einem der Ansprüche 1 bis 5, wobei im genannten Schritt (6) des Anschließens die Spannungsmesseinheit (7) ferner an den Außenleiter (A) des genannten Verbraucheranschlusses (V) angeschlossen wird,
wobei im genannten Schritt (8) des Messens ferner ein zweiter zeitlicher Verlauf einer elektrischen Spannung (U_{Ri}) zwischen dem Außenleiter (A) und dem Neutralleiter (N) mit der Spannungsmesseinheit (7) gemessen wird,
wobei im genannten Schritt (10) des Errechnens für jede Netzphase mithilfe einer Fourier-Transformierten des gemessenen ersten zeitlichen Verlaufs ein eigener Spannungswert mit zugehörigem Phasenwinkel gegenüber dieser Netzphase errechnet wird, und wobei im genannten Schritt (11) des Ermittelns die elektrische Leistungsaufnahme in jeder Netzphase des Haushaltsnetzes (1) ermittelt wird.

7. Verfahren nach einem der Ansprüche 3 bis 6, wobei der genannte Schritt (8) des Messens über eine Zeitspanne von zwei ganzen Netzperioden, bevorzugt beginnend mit einem Nulldurchgang des genannten zweiten zeitlichen Verlaufs der elektrischen Spannung (U_{Ri}) zwischen dem Außenleiter (A) und dem Neutralleiter (N), besonders bevorzugt beginnend mit einem Nulldurchgang von negativer zu positiver Spannung, durchgeführt wird.

8. Verfahren nach einem der Ansprüche 1 bis 7, wobei das Verfahren (4) wiederholt ausgeführt und im genannten Schritt (10) des Errechnens für jede Netzphase ermittelt wird, ob gegenüber der vorhergehenden Ausführungswiederholung ein Spannungssprung aufgetreten ist, und wobei im genannten Schritt (10) des Errechnens der Spannungswert (uᵢ, u_{i,0}) für diese Netzphase durch Kombination des für diese Netzphase in der vorhergehenden Ausführungswiederholung errechneten Spannungswerts (uᵢ, u_{i,0}) und des ermittelten Spannungssprungs errechnet wird.

9. Verfahren nach einem der Ansprüche 1 bis 8, ferner umfassend ein dem genannten Schritt (11) des Ermittelns vorgelagertes Bestimmen (16) des zumindest einen Referenzwerts (RV) mit den Teilschritten:
Anschließen und Einschalten eines Verbrauchers mit vorbekannter Leistung an den Leitungszweig (Lᵢ) mit dem Verbraucheranschluss (V), an welchen die Spannungsmesseinheit (7) angeschlossen ist;
Messen eines ersten zeitlichen Verlaufs (u_{Mi}) einer elektrischen Spannung (U_{Mi}) zwischen dem Neutralleiter (N) und dem Schutzleiter (PE) mit der Spannungsmesseinheit (7) vor und nach dem Einschalten des Verbrauchers; und
Errechnen jeweils zumindest eines Spannungswerts (uᵢ, u_{i,0}) aus dem gemessenen ersten zeitlichen Verlauf (u_{Mi}) der elektrischen Spannung (U_{Mi}) vor und nach dem Einschalten des Verbrauchers und Bestimmen des zumindest einen Referenzwerts (RV) aus der Differenz der errechneten Spannungswerte (uᵢ, u_{i,0}) vor und nach dem Einschalten des Verbrauchers.

10. Verfahren nach einem der Ansprüche 1 bis 9, ferner umfassend ein begleitendes Kalibrieren (17) des zumindest einen Referenzwerts (RV), wobei das Verfahren (4) wiederholt ausgeführt und der im genannten Schritt (10) des Errechnens errechnete Spannungswert (uᵢ, u_{i,0}) wiederholt mit dem zumindest einen Referenzwert (RV) verglichen und bei Überschreiten als zumindest ein neuer Referenzwert (RV) gespeichert wird.

11. Verfahren nach einem der Ansprüche 1 bis 10, wobei im genannten Schritt (6) des Anschließens an zwei in verschiedenen Leitungszweigen (Lᵢ) ein und derselben oder zweier verschiedener Netzphase/n des Haushaltsnetzes (1) liegende Verbraucheranschlüsse (V) jeweils eine Spannungsmesseinheit (7) an den Neutralleiter (N) und den Schutzleiter (PE) angeschlossen wird, und wobei in einem zusätzlichen Schritt (15) des Übertragens entweder die von den beiden Spannungsmesseinheiten (7) im genannten Schritt (8) des Messens jeweils gemessenen zeitlichen Verläufe (u_{Mi}) oder die aus den jeweils gemessenen zeitlichen Verläufen (u_{Mi}) errechneten Spannungswerte (uᵢ, u_{i,0}) an eine zentrale Recheneinheit (9) übertragen werden, welche entweder anhand der übertragenen zeitlichen Verläufe (u_{Mi}) die genannten Schritte (10, 11) des Errechnens und Ermittelns oder anhand der übertragenen Spannungswerte (uᵢ, u_{i,0}) den genannten Schritt (11) des Ermittelns ausführt.

12. Leistungsmessgerät zum Ermitteln der elektrischen Leistungsaufnahme in einem mit einem Versorgungsnetz verbundenen Haushaltsnetz (1), welches eine oder mehrere Netzphasen mit jeweils einem oder mehreren Leitungszweigen (Lᵢ) und in jedem Leitungszweig (Lᵢ) mehrere Verbraucheranschlüsse (V) mit jeweils einem Außenleiter (A), einem Neutralleiter (N) und einem Schutzleiter (PE) hat, wobei der Neutralleiter (N) und der Schutzleiter (PE) an einen Anlagenerder (E) des Haushaltsnetzes (1) angeschlossen sind, mit
einer Spannungsmesseinheit (7) , welche an den Neutralleiter (N) und den Schutzleiter (PE) eines der Verbraucheranschlüsse (V) anschließbar und dazu ausgebildet ist, den Schritt (8) des Messens des Verfahrens (4) nach Anspruch 1 oder 2 auszuführen, und
einer Recheneinheit (9), welche an die Spannungsmesseinheit (7) angeschlossen und dazu ausgebildet ist, die Schritte (10, 11) des Errechnens und Ermittelns des Verfahrens (4) nach Anspruch 1 oder 2 auszuführen.

13. Leistungsmessgerät nach Anspruch 12, wobei die Spannungsmesseinheit (7) ferner an den Außenleiter (A) des genannten Verbraucheranschlusses (V) anschließbar und dazu ausgebildet ist, den Schritt (8) des Messens des Verfahrens (4) nach einem der Ansprüche 3 bis 8 auszuführen, und wobei die Recheneinheit (9) dazu ausgebildet ist, die Schritte (10, 11) des Errechnens und Ermittelns des Verfahrens (4) nach einem der Ansprüche 3 bis 8 auszuführen.

14. Leistungsmessgerät nach Anspruch 12 oder 13, wobei die Recheneinheit (9) ferner dazu ausgebildet ist, das Bestimmen (16) des Referenzwerts (RV) des Verfahrens (4) nach Anspruch 10 und/oder das Kalibrieren (17) des Verfahrens (4) nach Anspruch 9 auszuführen.

15. Messsystem mit zumindest zwei Leistungsmessgeräten (5) nach einem der Ansprüche 12 bis 14, deren Spannungsmesseinheiten (7) an jeweils einen Verbraucheranschluss (V) anschließbar sind, welche Verbraucheranschlüsse (V) in verschiedenen Leitungszweigen (Lᵢ) ein und derselben oder zweier verschiedener Netzphase/n des Haushaltsnetzes (1) liegen, wobei eines der Leistungsmessgeräte (5) einen Sender (TR) und das andere Leistungsmessgerät (5) einen Empfänger (TR) und jene Recheneinheit (9) hat, welche die zentrale Recheneinheit (9) des Verfahrens (4) nach Anspruch 11 bildet, und wobei das genannte eine Leistungsmessgerät (5) dazu ausgebildet ist, entweder den von seiner Spannungsmesseinheit (7) gemessenen ersten zeitlichen Verlauf (u_{Mi}) oder den von seiner Recheneinheit (9) aus dem gemessenen ersten zeitlichen Verlauf (u_{Mi}) jeweils errechneten Spannungswert (uᵢ, u_{i,0}) über den Sender (TR) an die Recheneinheit (9) des genannten anderen Leistungsmessgeräts (5) zu übertragen, und das genannte andere Leistungsmessgerät (5) dazu ausgebildet ist, den von seiner Spannungsmesseinheit (7) gemessenen ersten zeitlichen Verlauf (u_{Mi}) an seine Recheneinheit (9) zu übertragen und die genannten Schritte (10, 11) des Errechnens und Ermittelns anhand des/der übertragenen ersten zeitlichen Verlaufs/Verläufe (u_{Mi}) und anhand der übertragenen und/oder errechneten Spannungswerte (uᵢ, u_{i,0}) auszuführen.
